# EUROPÄISCHE PATENTSCHRIFT

(11) **EP 3 129 775 B1**
(45) Veröffentlichungstag und Bekanntmachung des Hinweises auf die Patenterteilung: **10.11.2021**
(21) Anmeldenummer: 15705998.1
(22) Anmeldetag: 20.02.2015
(51) Int. Cl.: G01N 27/407, G01K 7/26, G01K 13/02, G01K 13/024, H05K 3/42

(54) **VERFAHREN ZUM HERSTELLEN EINES SENSORELEMENTS ZUR ERFASSUNG MINDESTENS EINER EIGENSCHAFT EINES MESSGASES IN EINEM MESSGASRAUM**
METHOD FOR PRODUCING A SENSOR ELEMENT FOR DETECTING AT LEAST ONE PROPERTY OF A MEASURED GAS IN A MEASURED GAS CHAMBER
PROCÉDÉ DE FABRICATION D'UN ÉLÉMENT CAPTEUR POUR LA DÉTECTION D'AU MOINS UNE PROPRIÉTÉ D'UN GAZ DE MESURE À L'INTÉRIEUR D'UNE CHAMBRE À GAZ DE MESURE

(30) Priorität: 10.04.2014 DE 102014206958
(43) Veröffentlichungstag der Anmeldung: 15.02.2017
(73) Patentinhaber: Robert Bosch GmbH, 70442 Stuttgart (DE)
(72) Erfinder: JUESTEL, Thomas, 96114 Hirschaid-Juliushof (DE); DOTTERWEICH, Oliver, 96173 Oberhaid (DE); TAEUBER, Antje, 96114 Hirschaid (DE); SCHNEIDER, Jens, 71229 Leonberg (DE); BUSE, Frank, 70437 Stuttgart (DE); ALT, Peter, 96158 Frensdorf (DE); BISCHOFF, Alexander, 71735 Eberdingen (DE); ROTTMANN, Andreas, 96188 Stettfeld (DE)
(86) Internationale Anmeldenummer: PCT/EP2015/053565
(87) Internationale Veröffentlichungsnummer: WO 2015/154905

(56) Entgegenhaltungen:
- EP-A1- 2 058 650
- WO-A1-03/102569
- US-A- 5 142 266
- US-A1- 2011 162 436
- US-B2- 7 084 350

## Beschreibung

### Stand der Technik

Aus dem Stand der Technik ist eine Vielzahl von Sensorelementen und Verfahren zur Erfassung mindestens einer Eigenschaft eines Messgases in einem Messgasraum bekannt. Dabei kann es sich grundsätzlich um beliebige physikalische und/oder chemische Eigenschaften handeln, wobei eine oder mehrere Eigenschaften erfasst werden können. Die Erfindung wird im Folgenden insbesondere unter Bezugnahme auf eine qualitative und/oder quantitative Erfassung eines Anteils einer Gaskomponente des Messgases beschrieben, insbesondere unter Bezugnahme auf eine Erfassung eines Sauerstoffanteils in dem Messgas. Der Sauerstoffanteil kann beispielsweise in Form eines Partialdrucks und/oder in Form eines Prozentsatzes erfasst werden. Alternativ oder zusätzlich sind jedoch auch andere Eigenschaften des Messgases erfassbar, wie beispielsweise die Temperatur.

Beispielsweise können derartige Sensorelemente als so genannte Lambdasonden ausgestaltet sein, wie sie beispielsweise aus Konrad Reif (Hrsg.): Sensoren im Kraftfahrzeug, 1. Aufl., 2010, Seiten 160-165 bekannt sind. Mit Breitband-Lambdasonden, insbesondere mit planaren Breitband-Lambdasonden, kann beispielsweise die Sauerstoffkonzentration im Abgas in einem großen Bereich bestimmt und damit auf das Luft-Kraftstoff-Verhältnis im Brennraum geschlossen werden. Die Luftzahl 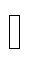 beschreibt dieses Luft-Kraftstoff-Verhältnis.

Aus dem Stand der Technik sind insbesondere keramische Sensorelemente bekannt, welche auf der Verwendung von elektrolytischen Eigenschaften bestimmter Festkörper basieren, also auf Ionen leitenden Eigenschaften dieser Festkörper. Insbesondere kann es sich bei diesen Festkörpern um keramische Festelektrolyte handeln, wie beispielsweise Zirkoniumdioxid (ZrO₂), insbesondere yttriumstabilisiertes Zirkoniumdioxid (YSZ) und scandiumdotiertes Zirkoniumdioxid (ScSZ), die geringe Zusätze an Aluminiumoxid (Al₂O₃) und/oder Siliziumoxid (SiO₂) enthalten können. So ist bei derartigen Sensorelementen beispielsweise ein laminierter Aufbau aus keramischen Folien mit innen liegenden Heizer- und Elektrodenstrukturen bekannt, die über ein Durchkontaktierloch mit einer Spannungsquelle und/oder Auswerteeinheit verbunden sind.

Trotz der zahlreichen Vorteile der aus dem Stand der Technik bekannten Sensorelemente beinhalten diese noch Verbesserungspotenzial. An derartige Sensorelemente werden steigende Funktionsanforderungen gestellt. Für eine robuste und zuverlässige Ausgestaltung des Durchkontaktierlochs müssen verschiedene und teilweise einander gegenläufige Anforderungen erfüllt werden. So muss ein hoher elektrischer Widerstand zwischen den Durchkontaktierlöchern auch bei Betriebstemperaturen oberhalb von 500 °C gegeben sein. Dies kann beispielsweise durch eine Isolationsschicht aus einem elektrisch isolierenden Material wie beispielsweise Aluminiumoxid realisiert werden. Die mechanische Grundfestigkeit der YSZ-Trägerkörperkeramik darf durch die Einbringung von mehreren Durchkontaktierlöchern nur geringfügig geschwächt werden. Dies kann durch kleine Durchmesser und glatte, rissfreie Wände der Durchkontaktierlöcher realisiert werden. Die Durchkontaktierlöcher sollten durch stabile und kostengünstige, im Mehrfachnutzen anwendbare Fertigungsprozesse hergestellt werden. Dies kann beispielsweise durch Mehrfachstanzung, Bohrung oder Stapelsaugen realisiert werden. Des Weiteren muss eine Zerrüttung der YSZ-Trägerkeramik durch hydrothermale Alterung über die Lebensdauer des Sensorelements verhindert werden. Die hydrothermale Alterung bedingt insbesondere eine Phasenumwandlung des Zirkoniumdioxids von der tetragonalen Phase in die monokline Phase, was zu einer mechanischen Zerrüttung oder gar einem Bruch der geschwächten Keramik bei Vibration oder Schlägen führen kann. Die Phasenumwandlung kann insbesondere im Bereich des Stanzgrats, einer dünnen Durchkontaktierung, einer niobfreien Anschlusskontaktpaste und einer fehlenden Isolation beginnen.

Ein Verfahren zum Herstellen eines schichtförmig aufgebauten Sensorelements ist beispielsweise aus der US5142266 A bekannt.

### Offenbarung der Erfindung

Es wird daher ein Verfahren zum Herstellen eines Sensorelements zur Erfassung mindestens einer Eigenschaft eines Messgases in einem Messgasraum vorgeschlagen, welche die Nachteile bekannter Herstellungsverfahren zumindest weitgehend vermeiden und bei denen insbesondere eine erhöhte Stabilität gegen Zerrüttung durch Phasenumwandlung gegeben ist.

Ein Sensorelement zur Erfassung mindestens einer Eigenschaft eines Messgases in einem Messgasraum, insbesondere zum Nachweis eines Anteils einer Gaskomponente in dem Messgas oder einer Temperatur des Messgases, wobei das Sensorelement nicht Teil der Erfindung ist, umfasst mindestens eine Festelektrolytschicht, wobei die Festelektrolytschicht mindestens ein Durchkontaktierloch aufweist, und ein Leitelement, das eine elektrisch leitende Verbindung von einer Oberseite der Festelektrolytschicht zu einer Unterseite der Festelektrolytschicht durch das Durchkontaktierloch herstellt. Die Festelektrolytschicht ist in dem Durchkontaktierloch von dem Leitelement durch ein Isolationselement elektrisch isoliert. Mindestens ein Öffnungsbereich des Durchkontaktierlochs ist mit einem Stabilisierungselement gegen Phasenumwandlung stabilisiert. Das Stabilisierungselement ist zumindest teilweise aus einem Material hergestellt, das ein Edelmetall und ein Element aufweist ausgewählt aus der Gruppe bestehend aus V, Nb, Ta, Sb, Bi, Cr, Mo, W.

Das Edelmetall kann Platin sein. Ein Anteil des Elements in dem Material kann von 2 Gew.-% bis 10 Gew.-% sein. Das Element kann in Form mindestens einer Verbindung vorliegen ausgewählt aus der Gruppe bestehend aus Oxid, Oxichlorid, Carbonat, Carbid und Chlorid. Das Stabilisierungselement kann den Öffnungsbereich in einer Umfangsrichtung vollständig umgeben. Beispielsweise umgibt das Stabilisierungselement den Öffnungsbereich ringförmig. Das Isolationselement kann zumindest teilweise aus einem Material hergestellt sein, das ein oxidisches Dielektrikum ist. Das Dielektrikum ist beispielsweise ein Metalloxid oder ein Erdalkalispinell.

Ein erfindungsgemäßes Verfahren zum Herstellen eines Sensorelements zur Erfassung mindestens einer Eigenschaft eines Messgases in einem Messgasraum, insbesondere zum Nachweis eines Anteils einer Gaskomponente in dem Messgas oder einer Temperatur des Messgases, umfasst gemäß dem unabhängigen Anspruch 1 die folgenden Schritte, in der angegebenen Reihenfolge:
- Bereitstellen mindestens einer Festelektrolytschicht,
- Einbringen mindestens eines Durchkontaktierlochs in die Festelektrolytschicht, das sich von einer Oberseite der Festelektrolytschicht zu einer Unterseite der Festelektrolytschicht erstreckt,
- Einbringen einer Isolationspaste in das Durchkontaktierloch, nachfolgend Einbringen einer Leitpaste in das Durchkontaktierloch,
- Nachfolgend Aufbringen einer Stabilisierungspaste gegen Phasenumwandlung auf mindestens einen Öffnungsbereich des Durchkontaktierlochs, wobei die Stabilisierungspaste ein Material aufweist, das ein Edelmetall und ein Element ausgewählt aus der Gruppe bestehend aus V, Nb, Ta, Sb, Bi, Cr, Mo, W aufweist, wobei die Stabilisierungspaste so aufgebracht wird, dass sie den Öffnungsbereich ringförmig umgibt, und
- Sintern des Sensorelements mit der Isolationspaste, der Leitpaste und der Stabilisierungspaste.

Das Edelmetall kann Platin sein. Ein Anteil des Elements in dem Material kann von 2 Gew.-% bis 10 Gew.-% sein. Das Element kann in Form mindestens einer Verbindung vorliegen ausgewählt aus der Gruppe bestehend aus Oxid, Oxichlorid, Carbonat, Carbid und Chlorid.

Die Stabilisierungspaste wird so aufgebracht, dass sie den Öffnungsbereich in einer Umfangsrichtung vollständig umgibt. Die Stabilisierungspaste wird so aufgebracht, dass sie den Öffnungsbereich ringförmig umgibt. Die Isolationspaste kann ein Material aufweisen, das ein oxidisches Dielektrikum ist. Das Dielektrikum kann ein Metalloxid oder ein Erdalkalispinell sein. Die Stabilisierungspaste kann schichtförmig aufgebracht werden. Die Stabilisierungspaste kann mit einem Druckverfahren aufgebracht werden. Die Isolationspaste und/oder die Leitpaste kann durch mindestens ein Durchsaugverfahren oder durch mindestens ein geeignetes Druckverfahren eingebracht werden.

Unter einer Festelektrolytschicht ist im Rahmen der vorliegenden Erfindung ein schichtförmiger Körper oder Gegenstand mit elektrolytischen Eigenschaften, also mit Ionen leitenden Eigenschaften, zu verstehen. Insbesondere kann es sich um eine keramische Festelektrolytschicht handeln. Dies umfasst auch das Rohmaterial einer Festelektrolytschicht und daher die Ausbildung als so genannter Grünling oder Braunling, die erst nach einem Sintern zu einem Festelektrolyten werden.

Unter einer Schicht ist im Rahmen der vorliegenden Erfindung eine flächenhafte Ausdehnung einer einheitlichen Masse in gewisser Höhe zu verstehen, die sich zwischen, über, unter oder auf anderen Elementen befinden kann.

Unter einem Isolationselement ist im Rahmen der vorliegenden Erfindung ein Körper oder Gegenstand mit elektrisch isolierenden Eigenschaften zu verstehen. Analog ist unter einer Isolationspaste ein Material in Pastenform zu verstehen, das nach einem Behandlungsschritt, insbesondere einem thermischen Behandlungsschritt, wie beispielsweise Sintern, ein Isolationselement bildet.

Unter einem Leitelement ist im Rahmen der vorliegenden Erfindung ein Körper oder Gegenstand mit elektrisch leitfähigen Eigenschaften zu verstehen. Analog ist unter einer Leitpaste ein Material in Pastenform zu verstehen, das nach einem Behandlungsschritt, insbesondere einem thermischen Behandlungsschritt, wie beispielsweise Sintern, ein Leitelement bildet.

Unter einem Stabilisierungselement ist im Rahmen der vorliegenden Erfindung ein Körper oder Gegenstand stabilisierenden Eigenschaften gegen Zerrüttung durch hydrothermale Alterung, die zu Phasenumwandlung führen kann, zu verstehen. Analog ist unter einer Stabilisierungspaste ein Material in Pastenform zu verstehen, das nach einem Behandlungsschritt, insbesondere einem thermischen Behandlungsschritt, wie beispielsweise Sintern, ein Stabilisierungselement bildet.

Unter einer Phase eines Werkstoffs ist im Rahmen der vorliegenden Erfindung die Eigenschaft des Werkstoffs zu verstehen, in verschiedenen Erscheinungsformen vorzukommen. So weist der Werkstoff die gleiche chemische Zusammensetzung (Stöchiometrie) auf, unterscheidet sich aber in der räumlichen Anordnung der Atome und weist unterschiedliche Eigenschaften auf.

Unter einer Phasenumwandlung ist im Rahmen der vorliegenden Erfindung ein Übergang eines Werkstoffs von einer Phase in eine andere zu verstehen. Der Übergang kann somit unterschiedliche Strukturen des Werkstoffs bewirken. Die Phasenumwandlung wird durch Einflüsse wie Druck und/oder Temperatur bewirkt. So kommt Zirkoniumdioxid beispielsweise in mehreren Phasen vor. Unterhalb einer Temperatur von 1173 °C liegt Zirkoniumdioxid in der monoklinen Phase vor, oberhalb davon in der tetragonalen Phase und oberhalb von 2370 °C in der kubischen Phase. Oberhalb von 2690 °C liegt das Zirkoniumdioxid als Schmelze vor.

### Kurze Beschreibung der Zeichnungen

Weitere optionale Einzelheiten und Merkmale der Erfindung ergeben sich aus der nachfolgenden Beschreibung bevorzugter Ausführungsbeispiele, welche in den Figuren schematisch dargestellt sind.

Es zeigen:
Figur 1 eine Explosionsdarstellung eines Sensorelements,
Figur 2 eine teilweise Querschnittsansicht des Sensorelements im Bereich eines
Durchkontaktierlochs,
Figur 3 eine Unteransicht auf einen Teil des Sensorelements und
Figur 4 eine Explosionsdarstellung eines Teils des Sensorelements.

### Ausführungsformen der Erfindung

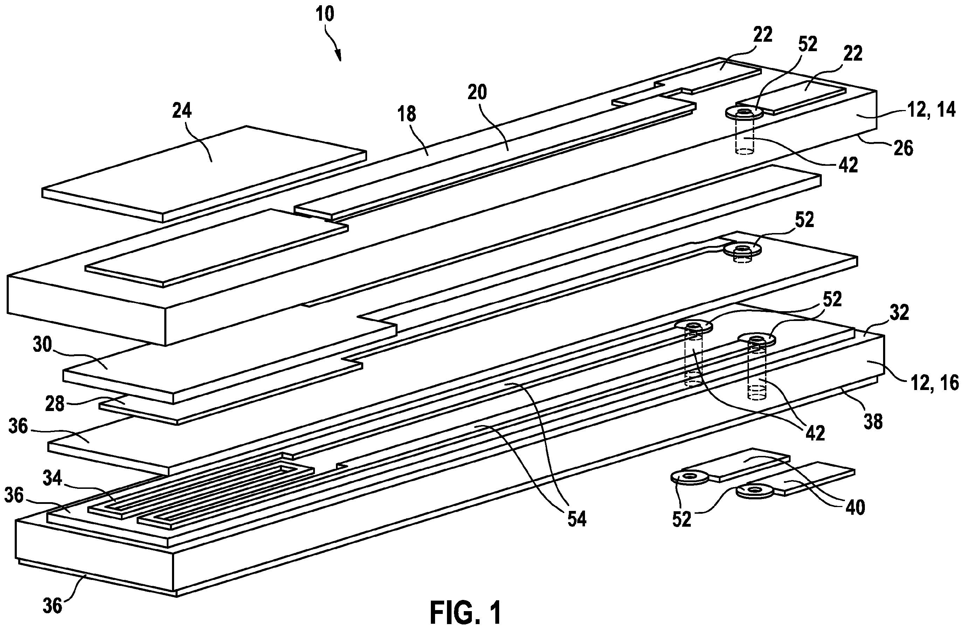

Figur 1 zeigt eine Explosionsdarstellung eines Sensorelements 10. Das in Figur 1 dargestellte Sensorelement 10 kann zum Nachweis von physikalischen und/oder chemischen Eigenschaften eines Messgases verwendet werden, wobei eine oder mehrere Eigenschaften erfasst werden können. Das erfindungsgemäße Verfahren wird im Folgenden insbesondere unter Bezugnahme auf eine qualitative und/oder quantitative Erfassung einer Gaskomponente des Gases beschrieben, insbesondere unter Bezugnahme auf eine Erfassung eines Sauerstoffanteils in dem Messgas. Der Sauerstoffanteil kann beispielsweise in Form eines Partialdrucks und/oder in Form eines Prozentsatzes erfasst werden. Grundsätzlich sind jedoch auch andere Arten von Gaskomponenten erfassbar, beispielsweise Stickoxide, Kohlenwasserstoffe, Rußpartikel und/oder Wasserstoff. Alternativ oder zusätzlich sind jedoch auch andere Eigenschaften des Messgases erfassbar, wie beispielsweise die Temperatur. Die Erfindung ist insbesondere im Bereich der Kraftfahrzeugtechnik einsetzbar, so dass es sich bei dem Messgasraum insbesondere um einen Abgastrakt einer Brennkraftmaschine handeln kann und bei dem Messgas insbesondere um ein Abgas.

Das Sensorelement 10, das nicht Teil der Erfindung ist, kann entsprechend exemplarisch Bestandteil einer planaren Lambdasonde sein und weist mindestens eine Festelektrolytschicht 12 auf. Bei der Festelektrolytschicht 12 kann es sich insbesondere um eine keramische Festelektrolytschicht 12 handeln, wie beispielsweise Zirkoniumdioxid, insbesondere yttriumstabilisiertes Zirkoniumdioxid und scandiumdotiertes Zirkoniumdioxid, das geringe Zusätze an Aluminiumoxid und/oder Siliziumoxid enthalten kann. Lediglich beispielhaft sind eine erste Festelektrolytschicht 14 und eine zweite Festelektrolytschicht 16 vorgesehen. Die erste Festelektrolytschicht 14 und die zweite Festelektrolytschicht 16 weisen jeweils eine Schichtdicke von 150 µm bis 850 auf, beispielsweise 500 µm. Auf einer Oberseite 18 der ersten Festelektrolytschicht 14 sind eine Außenelektrode 20 und Anschlusskontakte 22 angeordnet. Die Außenelektrode 20 kann von einer porösen Schutzschicht 24 zumindest teilweise bedeckt sein. Auf einer Unterseite 26 der ersten Festelektrolytschicht 14 ist eine innere Elektrode 28, die als Referenzelektrode dienen kann, in einem Referenzgaskanal 30 angeordnet.

Unterhalb der ersten Festelektrolytschicht 14 ist die zweite Festelektrolytschicht 16 angeordnet. Auf einer Oberseite 32 der zweiten Festelektrolytschicht 16 ist ein Heizelement 34, das zwischen zwei Isolationsschichten 36 eingebettet ist, angeordnet. Auf einer Unterseite 38 der zweiten Festelektrolytschicht 16 sind Anschlusskontakte 40 angeordnet.

Insgesamt sind bei dem Sensorelement 10 zum elektrischen Kontaktieren der inneren Elektrode 28 sowie des Heizelements 34 mehrere Durchkontaktierlöcher 42 angrenzend an die Anschlusskontakte 22, 40 vorgesehen, wie nachstehend näher beschrieben wird. Genauer weist die erste Festelektrolytschicht 14 ein Durchkontaktierloch 42 auf und die zweite Festelektrolytschicht 16 weist zwei Durchkontaktierlöcher 42 auf. Die Durchkontaktierlöcher 42 können als Bohr- und/oder Stanzloch ausgebildet sein. Die Durchkontaktierlöcher 42 weisen jeweils einen Durchmesser von 400 µm bis 1000 µm auf, beispielsweise 600 µm. Da die Durchkontaktierlöcher 42 zum elektrischen Kontaktieren elektrischer Bauteile dienen, versteht es sich, dass die Anzahl der Durchkontaktierlöcher 42 von der Anzahl der zu kontaktierenden Bauteile abhängt. Entsprechend können in Abhängigkeit von der Anzahl der zu kontaktierenden Bauteile mehr oder wendiger Durchkontaktierlöcher 42 als oben beschrieben vorgesehen sein. Die Durchkontaktierlöcher 42 erstrecken sich vollständig durch bzw. durchdringen die erste Festelektrolytschicht 14 und die zweite Festelektrolytschicht 16. Mit anderen Worten erstreckt sich das Durchkontaktierloch 42 der ersten Festelektrolytschicht 14 von der Oberseite 18 zu der Unterseite 26 bzw. umgekehrt und die Durchkontaktierlöcher 42 der zweiten Festelektrolytschicht 16 erstrecken sich von der Oberseite 32 zu der Unterseite 38. Lediglich beispielhaft wird anhand der zweiten Festelektrolytschicht 16 der Aufbau des Sensorelements 10 im Bereich eines Durchkontaktierlochs 42 nachstehend beschrieben. Der Aufbau des Sensorelements 10 im Bereich eines Durchkontaktierlochs 42 der ersten Festelektrolytschicht 16 ist im Wesentlichen identisch, so dass nachstehend nicht auf Gemeinsamkeiten zwischen der ersten Festelektrolytschicht 14 und der zweiten Festelektrolytschicht 16 eingegangen wird, sondern ausschließlich auf die Unterschiede.

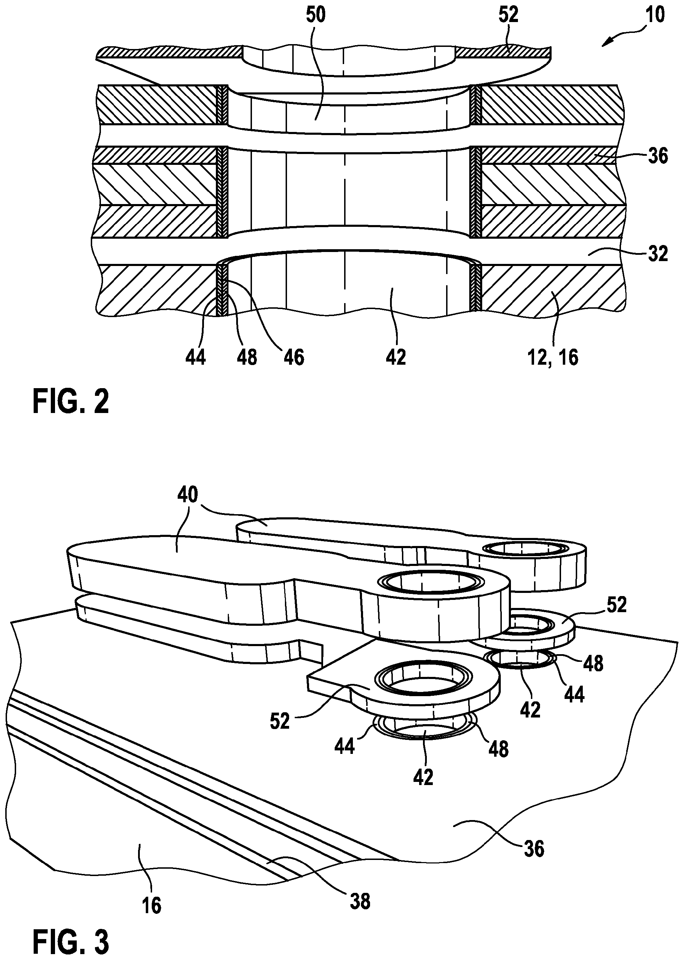

Figur 2 zeigt eine teilweise Querschnittsansicht des Sensorelements 10 im Bereich eines Durchkontaktierlochs. Genauer ist in Figur 2 ein teilweiser Querschnitt der zweiten Festelektrolytschicht 16 dargestellt. Auf der Oberseite 32 ist die Isolationsschicht 36 angeordnet. Obgleich nicht näher in Figur 2 dargestellt, kann auf der Unterseite 38 der zweiten Festelektrolytschicht 16 ebenfalls eine Isolationsschicht 36 angeordnet sein. Das Durchkontaktierloch 42 erstreckt sich dabei von der Oberseite 32 zu der Unterseite 38. Das Durchkontaktierloch 42 durchdringt dabei auch die Isolationsschichten 36. Im Inneren des Durchkontaktierlochs 42 ist ein schichtförmig ausgebildetes Isolationselement 44 angeordnet. Das schichtförmige Isolationselement 44 weist eine Schichtdicke von 5 µm bis 40 µm auf, beispielsweise 20 µm. Das Isolationselement 44 ist aus mindestens einem elektrisch isolierenden Material hergestellt. Das Isolationselement 44 ist insbesondere zumindest teilweise aus einem Material hergestellt, das ein oxidisches Dielektrikum ist. Das Dielektrikum kann ein Metalloxid oder ein Erdalkalispinell sein. Das elektrisch isolierende Material weist beispielsweise Aluminiumoxid (Al₂O₃) auf. Das Isolationselement 44 bedeckt eine Wand 46 des Durchkontaktierlochs 42 vollständig. Das Isolationselement 44 bedeckt somit auch die Wand 46 des Durchkontaktierlochs 42 im Bereich der Isolationsschicht 36.

Auf dem Isolationselement 44 ist ein Leitelement 48 angeordnet. Das Leitelement 48 ist ebenfalls schichtförmig ausgebildet. Das schichtförmige Leitelement 48 weist eine Schichtdicke von 5 µm bis 15 µm auf, beispielsweise 10 µm. Das Leitelement 48 ist aus einem elektrisch leitfähigen Material hergestellt. Das elektrisch leitfähige Material weist beispielsweise ein Edelmetall, insbesondere Platin, auf. Das elektrisch leitfähige Material kann weitere Zusätze aufweisen, wie beispielsweise Nioboxid. Das Leitelement 48 bedeckt dabei das Isolationselement 44 vollständig. Durch diesen Aufbau stellt das Leitelement 48 eine elektrisch leitende Verbindung von der Oberseite 32 der zweiten Festelektrolytschicht 16 zu der Unterseite 38 der zweiten Festelektrolytschicht 16 durch das Durchkontaktierloch 42 her. Weiterhin ist die zweite Festelektrolytschicht 16 in dem Durchkontaktierloch 42 von dem Leitelement 48 durch das Isolationselement 44 elektrisch isoliert.

Ein Öffnungsbereich 50 des Durchkontaktierlochs 42 ist mit einem Stabilisierungselement 52 gegen Phasenumwandlung stabilisiert. Das Stabilisierungselement 52 ist aus einem Material hergestellt, das ein Edelmetall und ein Element aufweist ausgewählt aus der Gruppe bestehend aus V, Nb, Ta, Sb, Bi, Cr, Mo, W aufweist. Beispielsweise ist das Edelmetall Platin. Das Element kann in Form von mindestens einer Verbindung vorliegen, die ausgewählt ist aus der Gruppe bestehend aus Oxid, Oxichlorid, Carbonat, Carbid und Chlorid. Ein Anteil des Elements in dem Material des Stabilisierungselements 52 ist in jedem Fall von 2 Gew.-% bis 10 Gew.-%, beispielsweise 5 Gew.-%. Das Element ist beispielsweise Nb und liegt als Verbindung in Form von Nioboxid vor. Somit umfasst das Material des Stabilisierungselements 52 unter anderem Platin und Nioboxid. Das Stabilisierungselement 52 ist ebenfalls schichtförmig ausgebildet. Das schichtförmige Stabilisierungselement 52 weist eine Schichtdicke von 7 µm bis 11 µm auf, beispielsweise 9 µm. Das Stabilisierungselement 52 umgibt den Öffnungsbereich 50 in einer Umfangsrichtung vollständig. Beispielsweise ist das Stabilisierungselement 52 so angeordnet, dass es den Öffnungsbereich 50 ringförmig umgibt. Der Öffnungsbereich 50 kann als Mündungsbereich des Durchkontaktierlochs 42 aufgefasst werden, so dass das Stabilisierungselement 52 sich auch teilweise in das Durchkontaktierloch 42 hinein erstreckt.

Figur 3 zeigt eine Unteransicht auf einen Teil des Sensorelements 10. Genauer ist in Figur 3 die Unterseite 38 der zweiten Festelektrolytschicht 16 dargestellt. Wie in Figur 3 zu erkennen ist, ist auf der Unterseite 38 ebenfalls eine Isolationsschicht 36 angeordnet. Zu erkennen ist weiterhin die ringförmige Ausbildung der Stabilisierungselemente 52 jeweils im Öffnungsbereich 50 eines jeden Durchkontaktierlochs 42. Jeweils ein Stabilisierungselement 52 kontaktiert dabei einen Anschlusskontakt 40 elektrisch.

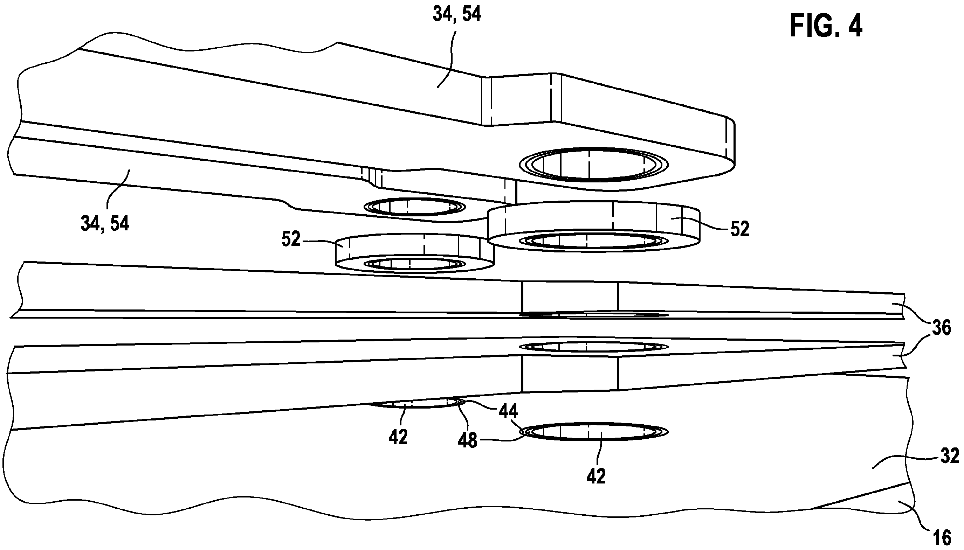

Figur 4 zeigt eine teilweise Explosionsdarstellung des Sensorelements 10. Genauer ist in Figur 4 die Oberseite 32 der zweiten Festelektrolytschicht 16 dargestellt. Wie in Figur 4 zu erkennen ist, ist auf der Oberseite 32 ebenfalls die Isolationsschicht 36 angeordnet. Zu erkennen ist weiterhin die ringförmige Ausbildung der Stabilisierungselemente 52 jeweils im Öffnungsbereich 50 eines jeden Durchkontaktierlochs 42. Jeweils ein Stabilisierungselement 52 kontaktiert dabei eine Zuleitungsbahn 54 des Heizelements 34 elektrisch.

Durch das Isolationselement 44 ist die zweite Festelektrolytschicht 16 von dem Leitelement 48 elektrisch isoliert. Allerdings entsteht durch das Stabilisierungselement 52 und das Leitelement 48 eine elektrische Kontaktierung von dem Anschlusskontakt 40 zu dem Heizelement 34 durch das Durchkontaktierloch 42 hindurch.

Der Aufbau des Sensorelements 10 im Bereich des Durchkontaktierlochs 42 der ersten Festelektrolytschicht 14 unterscheidet sich von dem Aufbau des Sensorelements 10 im Bereich des Durchkontaktierlochs 42 der zweiten Festelektrolytschicht 16 lediglich darin, dass bei der ersten Festelektrolytschicht 14 keine Isolationsschichten 36 vorgesehen sind. Analog entsteht somit bei der ersten Festelektrolytschicht 14 eine elektrische Kontaktierung von dem Anschlusskontakt 22 zu der inneren Elektrode 28 durch das Durchkontaktierloch 42 hindurch. Durch das erfindungsgemäße Vorsehen des Durchkontaktierlochs 42 mit dem Isolationselement 44, dem Leitelement 48 und dem Stabilisierungselement 52 wird ein großer Isolationswiderstand zwischen den Anschlusskontakten 22, 40 auch bei hohen Temperaturen, wie beispielsweise ein Widerstand von 100 kΩ bei einer Temperatur von 500 °C, und gleichzeitig eine zuverlässige Resilienz gegen Zerrüttung durch Phasenumwandlung im mittleren Temperaturbereich von 100 °C bis 400 °C bei Anwesenheit von Feuchtigkeit und/oder Wasser geschaffen.

Das Sensorelement 10 kann wie folgt hergestellt werden. Das Verfahren wird dabei lediglich beispielshaft anhand des Aufbaus bei der zweiten Festelektrolytschicht 16 beschrieben. Das Verfahren ist bei der ersten Festelektrolytschicht 14 identisch bis auf die oben beschriebenen Unterschiede.

Zunächst wird die Festelektrolytschicht 16 bereitgestellt. Die zweite Festelektrolytschicht 16 wird in einem ungesinterten Zustand bereitgestellt. Auf die Oberseite 32 und die Unterseite 34 werden die Isolationsschichten 36 aufgebracht. Beispielsweise werden die Isolationsschichten 36 als Folien auf die Oberseite 32 und die Unterseite 34 auflaminiert. In die zweite Festelektrolytschicht 14 werden die Durchkontaktierlöcher 42 eingebracht. Das Einbringen der Durchkontaktierlöcher 42 erfolgt dabei derart, dass sich die Durchkontaktierlöcher 42 von der Oberseite 32 bis zu der Unterseite 38 der zweiten Festelektrolytschicht 16 sowie durch die Isolationsschichten 36 erstrecken. Das Einbringen kann beispielsweise durch Stanzen, Prägen und/oder ein ein- oder zweiseitiges Bohren, insbesondere mittels Laserstrahlung, erfolgen.

Nachfolgend erfolgt ein ein- oder mehrfaches Einbringen einer Isolationspaste in die Durchkontaktierlöcher 42. Die Paste kann auch als Suspension vorliegen. Die Isolationspaste ist insbesondere zumindest teilweise aus einem Material hergestellt, das ein oxidisches Dielektrikum ist. Das Dielektrikum kann ein Metalloxid oder ein Erdalkalispinell sein. Das elektrisch isolierende Material weist beispielsweise Aluminiumoxid (Al₂O₃) auf. Das Einbringen kann beispielsweise durch Drucken, Siebdrucken, ein-oder zweiseitiges Saugen, Pressen, Sprühen und/oder Tropfen erfolgen. Beispielsweise wird die Isolationspaste durch ein Durchsaugverfahren eingebracht. Die Isolationspaste wird insbesondere schichtförmig mit einer Schichtdicke von 5 µm bis 40 µm eingebracht. Abschließend und bei mehrfachem Einbringen auch zusätzlich kann zwischenzeitlich eine Trocknung erfolgen.

Nachfolgend erfolgt ein ein- oder mehrfaches Einbringen einer Leitpaste in die Durchkontaktierlöcher 42. Die Leitpaste ist aus einem elektrisch leitfähigen Material hergestellt. Das elektrisch leitfähige Material weist beispielsweise ein Edelmetall, insbesondere Platin, auf. Das elektrisch leitfähige Material kann weitere Zusätze aufweisen, wie beispielsweise Nioboxid. Das Einbringen kann beispielsweise durch Drucken, Siebdrucken, ein- oder zweiseitiges Saugen, Pressen, Sprühen und/oder Tropfen erfolgen. Beispielsweise wird die Isolationspaste durch ein Durchsaugverfahren eingebracht. Die Leitpaste wird insbesondere schichtförmig mit einer Schichtdicke von 5 µm bis 15 µm eingebracht. Abschließend und bei mehrfachem Einbringen auch zusätzlich kann zwischenzeitlich eine Trocknung erfolgen.

Nachfolgend wird eine Stabilisierungspaste gegen Phasenumwandlung auf den Öffnungsbereich 50 aufgebracht. Die Stabilisierungspaste kann ein Material aufweisen, das ein Edelmetall, wie beispielsweise Platin, und ein Element aufweist, das ausgewählt ist aus der Gruppe bestehend aus V, Nb, Ta, Sb, Bi, Cr, Mo, W. Das Element kann in Form von mindestens einer Verbindung vorliegen, die ausgewählt ist aus der Gruppe bestehend aus Oxid, Oxichlorid, Carbonat, Carbid und Chlorid. Ein Anteil des Elements in dem Material der Stabilisierungspaste ist in jedem Fall von 2 Gew.-% bis 10 Gew.-%, beispielsweise 5 Gew.-%. Das Element ist beispielsweise Nb und liegt als Verbindung in Form von Nioboxid vor. Somit umfasst das Material der Stabilisierungspaste unter anderem Platin und Nioboxid. Die Stabilisierungspaste kann durch ein Druckverfahren aufgebracht werden. Beispielsweise wird die Stabilisierungspaste schichtförmig aufgedruckt. Die Stabilisierungspaste wird insbesondere schichtförmig mit einer Schichtdicke von 5 µm bis 15 µm aufgebracht. Die Stabilisierungspaste wird dabei ringförmig um den Öffnungsbereich 50 aufgebracht.

Eine genaue Zusammenfassung der Inhaltsstoffe der Isolationspaste, der Leitpaste und der Stabilisierungspaste kann wie folgt sein:

**A. Isolationspaste**

| Rohstoff | Gew.-% |
|---|---|
| Weichmacher | 2,0 - 5,0 % |
| Lösemittel | 25 - 45 % |
| Binderpolymer | 5,0 -10 % |
| AI203-bzw Spinell Pulver | 40 - 60 % |
| Flammruß | 2,0 - 6,0% |

**B. Leitpaste**

| Rohstoff | Gew.-% |
|---|---|
| Lösungsmittel + Binder | 25 - 45% |
| Pt-Pulver | 45 - 70 % |
| Pd-Pulver/Resinat | 0-5% |
| Rh-Pulver/Resinat | 0 - 5 % |
| Zirkon- Mischoxid | 2 -10 % |

**C. Stabilisierungspaste**

| Rohstoff | Gew.-% |
|---|---|
| Lösungsmittel + Binder | 25 - 45% |
| M(V)/M(VI)-Verbindung | 2 - 12% |
| Pt-Pulver | 40 - 65% |
| Pd-Pulver/Resinat | 0 - 5 % |
| Rh-Pulver/Resinat | 0 - 5 % |
| Stabilisiertes ZrO2 | 0- 10 % |

Im vorliegenden Ausführungsbeispiel sind die Rezepturen der Leitpaste und der Stabilisierungspaste sehr ähnlich. Dies ist aber nicht zwingend erforderlich. Entscheidend ist der mind. 2,0 Gew.-% Anteil einer Metallverbindung mit einem Metall der Oxidationsstufe +V oder +VI zur Gegendotierung der Metallionen mit einem Metall der Oxidationsstufe +II oder +III im phasen-stabilisierten Zirkoniumdioxid der Keramik der zweiten Festelektrolytschicht 16. Dies gilt entsprechend für die erste Festelektrolytschicht 14.

Abschließend folgt dann ein Sinterprozess des Sensorelements 10 mit sämtlichen aufgebrachten Pasten und allen aufeinander angeordneten Festelektrolytschichten 12, 14, 16. Das Sintern kann beispielsweise bei einer Temperatur von 1350 °C bis 1450 °C erfolgen. Dabei kommt es zu einem Kosintern der Festelektrolytschichten 12, 14, 16, der Isolationsschichten 36, der Isolationspaste, der Leitpaste und der Stabilisierungspaste. Durch den Sinterprozess bilden sich aus der Isolationspaste, der Leitpaste und der Stabilisierungspaste das Isolationselement 44, das Leitelement 48 und das Stabilisierungselement 52.

## Patentansprüche

1. Verfahren zum Herstellen eines Sensorelements (10) zur Erfassung mindestens einer Eigenschaft eines Messgases in einem Messgasraum, insbesondere zum Nachweis eines Anteils einer Gaskomponente in dem Messgas oder einer Temperatur des Messgases, umfassend die folgenden Schritte:
- Bereitstellen mindestens einer Festelektrolytschicht (12, 14, 16),
- Einbringen mindestens eines Durchkontaktierlochs (42) in die Festelektrolytschicht (12, 14, 16), das sich von einer Oberseite (18, 32) der Festelektrolytschicht (12, 14, 16) zu einer Unterseite (26, 38) der Festelektrolytschicht (12, 14, 16) erstreckt,
- Einbringen einer Isolationspaste in das Durchkontaktierloch (42), nachfolgend Einbringen einer Leitpaste in das Durchkontaktierloch (42),
- Nachfolgend Aufbringen einer Stabilisierungspaste gegen Phasenumwandlung auf mindestens einen Öffnungsbereich (50) des Durchkontaktierlochs (42), wobei die Stabilisierungspaste ein Material aufweist, das ein Edelmetall und ein Element ausgewählt aus der Gruppe bestehend aus V, Nb, Ta, Sb, Bi, Cr, Mo, W aufweist, wobei die Stabilisierungspaste so aufgebracht wird, dass sie den Öffnungsbereich (50) ringförmig umgibt, und
- Sintern des Sensorelements (10) mit der Isolationspaste, der Leitpaste und der Stabilisierungspaste.

2. Verfahren nach dem vorhergehenden Anspruch, wobei ein Anteil des Elements in dem Material von 2 Gew.-% bis 10 Gew.-% ist.

3. Verfahren nach einem der vorhergehenden Ansprüche, wobei das Element in Form mindestens einer Verbindung vorliegt ausgewählt aus der Gruppe bestehend aus Oxid, Oxichlorid, Carbonat, Carbid und Chlorid.

4. Verfahren nach einem der vorhergehenden Ansprüche, wobei die Stabilisierungspaste mit einem Druckverfahren aufgebracht wird.

5. Verfahren nach einem der vorhergehenden Ansprüche, wobei die Isolationspaste und/oder die Leitpaste durch mindestens ein Durchsaugverfahren eingebracht werden.

## Claims

1. Process for producing a sensor element (10) for detecting at least one property of an analysis gas in an analysis gas space, especially for detecting a proportion of a gas component in the analysis gas or a temperature of the analysis gas, comprising the following steps:
- providing at least one solid-state electrolyte layer (12, 14, 16),
- introducing at least one through-contacting hole (42) into the solid-state electrolyte layer (12, 14, 16) that extends from a top side (18, 32) of the solid-state electrolyte layer (12, 14, 16) to a bottom side (26, 38) of the solid-state electrolyte layer (12, 14, 16),
- introducing an insulating paste into the through-contacting hole (42), referred to hereinafter as introducing a conductive paste into the through-contacting hole (42),
- subsequently applying a stabilizing paste for countering phase transformation to at least one opening region (50) of the through-contacting hole (42), wherein the stabilizing paste includes a material including a precious metal and an element selected from the group consisting of V, Nb, Ta, Sb, Bi, Cr, Mo, W, wherein the stabilizing paste is applied such that it surrounds the opening region (50) in the form of a ring, and
- sintering the sensor element (10) with the insulating paste, the conductive paste and the stabilizing paste.

2. Process according to the preceding claim, wherein a proportion of the element in the material is from 2% by weight to 10% by weight.

3. Process according to either of the preceding claims, wherein the element is in the form of at least one compound selected from the group consisting of oxide, oxychloride, carbonate, carbide and chloride.

4. Process according to any of the preceding claims, wherein the stabilizing paste is applied by a printing process.

5. Process according to any of the preceding claims, wherein the insulating paste and/or the conductive paste are introduced by means of at least one through-suction process.

## Revendications

1. Procédé de fabrication d'un élément capteur (10) pour l'acquisition d'au moins une propriété d'un gaz de mesure dans une chambre à gaz de mesure, notamment pour la détection d'une proportion d'un composant gazeux dans le gaz de mesure ou d'une température du gaz de mesure, comprenant les étapes suivantes :
- la fourniture d'au moins une couche d'électrolyte solide (12, 14, 16),
- l'introduction d'au moins un trou de connexion traversant (42) dans la couche d'électrolyte solide (12, 14, 16), qui s'étend depuis un côté supérieur (18, 32) de la couche d'électrolyte solide (12, 14, 16) jusqu'à un côté inférieur (26, 38) de la couche d'électrolyte solide (12, 14, 16),
- l'introduction d'une pâte isolante dans le trou de connexion traversant (42), puis l'introduction d'une pâte conductrice dans le trou de connexion traversant (42),
- puis l'application d'une pâte stabilisatrice à l'encontre du changement de phases sur au moins une zone d'ouverture (50) du trou de connexion traversant (42), la pâte stabilisatrice comprenant un matériau qui comprend un métal noble et un élément choisi dans le groupe constitué par V, Nb, Ta, Sb, Bi, Cr, Mo, W, la pâte stabilisatrice étant appliquée de telle sorte qu'elle entoure sous forme annulaire la zone d'ouverture (50), et
- le frittage de l'élément capteur (10) avec la pâte isolante, la pâte conductrice et la pâte stabilisatrice.

2. Procédé selon la revendication précédente, dans lequel la proportion de l'élément dans le matériau est de 2 % en poids à 10 % en poids.

3. Procédé selon l'une quelconque des revendications précédentes, dans lequel l'élément se présente sous la forme d'au moins un composé choisi dans le groupe constitué par un oxyde, un oxychlorure, un carbonate, un carbure et un chlorure.

4. Procédé selon l'une quelconque des revendications précédentes, dans lequel la pâte stabilisatrice est appliquée avec un procédé d'impression.

5. Procédé selon l'une quelconque des revendications précédentes, dans lequel la pâte isolante et/ou la pâte conductrice sont introduites par au moins un procédé d'aspiration.
